# EUROPEAN PATENT APPLICATION

(11) **EP 4 535 954 A1**
(43) Date of publication of application: **09.04.2025**
(21) Application number: 23816026.1
(22) Date of filing: 29.05.2023
(51) Int. Cl.: H10B 61/00, H01L 29/82, H10N 50/10

(54) **MAGNETIC MEMORY ELEMENT, INFORMATION PROCESSING SYSTEM, AND MEHOD FOR CONTROLLING MAGNETIC MEMORY ELEMENT**

(30) Priority: 30.05.2022 JP 2022088105
(71) Applicant: The University of Tokyo, Bunkyo-ku, Tokyo 113-8654 (JP)
(72) Inventor: NAKATSUJI, Satoru, Tokyo 113-8654 (JP); HIGO, Tomoya, Tokyo 113-8654 (JP)
(74) Representative: Bandpay & Greuter
(86) International application number: PCT/JP2023/019977
(87) International publication number: WO 2023/234269

(57) **Abstract**

A magnetic memory element (100) includes: a substrate (10); a spin Hall layer (12) stacked on the substrate (10) and made of a material that exhibits a spin Hall effect (e.g., non-magnetic heavy metal), a write current I_{write} flowing through the spin Hall layer in an in-plane direction being configured to generate a spin current; and an antiferromagnetic layer (14) stacked on the spin Hall layer (12), having a tensile strain ε in an in-plane direction, and made of an antiferromagnetic metal containing manganese (e.g., Mn₃Sn), the spin current being configured to induce a spin-orbit torque that allows reversal of magnetization of the antiferromagnetic metal.

## Description

### Technical Field

The present invention relates to a magnetic memory element, an information processing system, and a method for controlling a magnetic memory element.

### Background Art

Ferromagnet-based magnetic random-access memories (MRAMs) have attracted attention as low-power memories for information processing because of their non-volatile nature. In fact, various semiconductor manufacturers employ MRAMs as alternatives to volatile memories such as static random-access memories (SRAMs). Examples of such MRAMs include an STT-MRAM that allows reversal of magnetization of a ferromagnet by a spin transfer torque (STT) and an SOT-MRAM that allows reversal of magnetization of a ferromagnet by a spin-orbit torque (SOT) (e.g., See Patent Literature 1).

### Citation List

### Patent Literature

Patent Literature 1: U.S. Patent No. 9,837,602

### Summary of Invention

### Technical Problem

Unfortunately, since the existing MRAMs use ferromagnets, reversal speed of magnetization is as slow as about one nanosecond. This makes it difficult to cope with a terahertz region (picosecond order) which especially grows increasingly significant in high-speed optical communications.

The invention has been made in view of the foregoing, and an object of the invention is to enable high-speed write and read operations by an antiferromagnet-based magnetic memory element.

### Solution to Problem

A magnetic memory element according to one aspect of the invention includes an antiferromagnetic layer having a uniaxial strain and made of an antiferromagnetic metal containing manganese. A spin torque is configured to allow manipulation of a magnetic order of the antiferromagnetic metal.

A magnetic memory element according to another aspect of the invention includes: a spin Hall layer made of a material that exhibits a spin Hall effect, a write current flowing through the spin Hall layer in an in-plane direction being configured to generate a spin current; a free layer stacked on the spin Hall layer, having a uniaxial strain, and made of an antiferromagnetic metal containing manganese, the spin current being configured to induce a spin-orbit torque that allows reversal of a magnetic order of the antiferromagnetic metal; a non-magnetic layer stacked on the free layer; and a reference layer stacked on the non-magnetic layer and made of a ferromagnetic metal or an antiferromagnetic metal containing manganese, a magnetic order of the ferromagnetic metal or the antiferromagnetic metal being fixed.

A magnetic memory element according to still another aspect of the invention includes: a reference layer made of a ferromagnetic metal or an antiferromagnetic metal containing manganese, a magnetic order of the ferromagnetic metal or the antiferromagnetic metal being fixed; a non-magnetic layer stacked on the reference layer; and a free layer stacked on the non-magnetic layer, having a uniaxial strain, and made of an antiferromagnetic metal containing manganese. A write current flowing through the magnetic memory element in an out-of-plane direction is configured to induce a spin transfer torque that allows reversal of a magnetic order of the antiferromagnetic metal in the free layer.

An information processing system according to still another aspect of the invention is an information processing system including the magnetic memory element described above.

An information processing system according to still another aspect of the invention is an information processing system including a magnetic memory device. The magnetic memory device includes a plurality of magnetic memory elements arranged in a matrix, each of the plurality of magnetic memory elements being defined as the magnetic memory element described above.

A method for controlling a magnetic memory element according to still another aspect of the invention is a method for controlling a magnetic memory element, the magnetic memory element including an antiferromagnetic layer having a uniaxial strain and made of an antiferromagnetic metal containing manganese. The method includes manipulating a magnetic order of the antiferromagnetic metal by a spin torque.

A method for controlling a magnetic memory element according to still another aspect of the invention is a method for controlling a magnetic memory element, the magnetic memory element including: a spin Hall layer made of a material that exhibits a spin Hall effect; a free layer stacked on the spin Hall layer, having a uniaxial strain, and made of an antiferromagnetic metal containing manganese; a non-magnetic layer stacked on the free layer; and a reference layer stacked on the non-magnetic layer and made of a ferromagnetic metal or an antiferromagnetic metal containing manganese, a magnetic order of the ferromagnetic metal or the antiferromagnetic metal being fixed. The method includes: a step of causing a write current to flow through the spin Hall layer in an in-plane direction to generate a spin current; and a step of reversing a magnetic order of the antiferromagnetic metal in the free layer by a spin-orbit torque induced by the spin current.

A method for controlling a magnetic memory element according to still another aspect of the invention is a method for controlling a magnetic memory element, the magnetic memory element including: a reference layer made of a ferromagnetic metal or an antiferromagnetic metal containing manganese, a magnetic order of the ferromagnetic metal or the antiferromagnetic metal being fixed; a non-magnetic layer stacked on the reference layer; and a free layer stacked on the non-magnetic layer, having a uniaxial strain, and made of an antiferromagnetic metal containing manganese. The method includes causing a write current to flow through the magnetic memory element in an out-of-plane direction, thereby reversing a magnetic order of the antiferromagnetic metal in the free layer by a spin transfer torque.

### Advantageous Effects of Invention

According to the invention, a magnetic memory element includes an antiferromagnetic layer having a uniaxial strain and made of an antiferromagnetic metal containing manganese, and a spin torque allows manipulation of a magnetic order of the antiferromagnetic metal. With this feature, it is possible to increase reversal speed of magnetization and achieve high-speed write and read operations.

### Brief Description of Drawings

FIG. 1 is a cross-sectional view of a magnetic memory element according to a first embodiment of the invention.
FIG. 2 is a schematic view of crystal and magnetic structures of Mn₃Sn.
FIG. 3 is a schematic view illustrating control of a magnetic state under in-plane tensile strain for an Mn₃Sn layer of a MgO-substrate/W/Mn₃Sn multilayer film.
FIG. 4A is a graph of X-ray diffraction patterns of 2θ/ω-scan for a MgO-substrate/W/Mn₃Sn/MgO sample and the MgO-substrate.
FIG. 4B is a graph of X-ray diffraction patterns of Φ-scan for the Mn₃Sn layer, the W layer, and the MgO substrate.
FIG. 4C is a cross-sectional transmission electron microscope (TEM) image of the Mn₃Sn layer.
FIG. 5 is a schematic view illustrating tensile strain for an Mn₃Sn layer of an epitaxial film.
FIG. 6A is a schematic view of a spin structure on kagome layers of the Mn₃Sn layer with no strain (ε=0).
FIG. 6B is a schematic view of binary states on the kagome layers of the Mn₃Sn layer stabilized by application of epitaxial, uniaxial-tensile strain (ε>0).
FIG. 7 is a schematic view of a configuration of a magnetic memory element with a Hall bar structure.
FIG. 8A is a graph of magnetic field dependence of a Hall voltage for a W/Mn₃Sn multilayer film on a MgO substrate.
FIG. 8B is a graph of write current dependence of the Hall voltage for the W/Mn₃Sn multilayer film on the MgO substrate.
FIG. 9 is a schematic view illustrating piezomagnetic effect in Mn₃Sn according to a second embodiment of the invention.
FIG. 10 is a schematic view of configurations of two Mn₃Sn samples (M1 and M2) with different compression directions.
FIG. 11 is graphs of magnetic field dependence of magnetization under various uniaxial stresses for the samples.
FIG. 12 is graphs of temperature dependence of magnetization under various uniaxial stresses for the samples.
FIG. 13 is a graph of uniaxial stress dependence of spontaneous magnetization and magnetic susceptibility for the samples.
FIG. 14 is a schematic view illustrating a Hall effect measurement for two Mn₃Sn samples (H1 and H2) with different strain directions.
FIG. 15A is a graph of magnetic field dependence of Hall resistivity under various strains for the sample H1.
FIG. 15B is a graph of magnetic field dependence of Hall resistivity under various strains for the sample H2.
FIG. 16 is a cross-sectional view of a magnetoresistance element constituting a magnetic memory element according to a third embodiment of the invention.
FIG. 17 is a schematic view illustrating resistance states of the magnetoresistance element shown in FIG. 16.
FIG. 18 is a schematic view of a configuration of a magnetic memory element for an SOT-MRAM.
FIG. 19 is a schematic view of a configuration of a magnetic memory element for an STT-MRAM.

### Description of Embodiments

Exemplary embodiments of the invention will be described below with reference to the accompanying drawings. The same reference signs are used to designate the same or similar elements throughout the drawings. The drawings are schematic, and a relationship between a planar dimension and a thickness and a thickness ratio between members are different from reality. Needless to say, there are portions having different dimensional relationships or ratios between the drawings.

In the embodiments, a multilayer film may be denoted by materials of layers constituting the multilayer film. For example, suppose that a material-b layer is stacked on a material-a layer, and a material-c layer is stacked on the material-b layer, this multilayer film is denoted by "material a/ material b/ material c." Furthermore, a material name of each layer may be followed by a thickness (nm) of the layer, placed in parentheses. For example, a material-j layer with a thickness of ti(nm) is denoted by "material j (ti)."

To achieve a fast operable non-volatile memory, the embodiments employ antiferromagnets instead of ferromagnets. The reason behind this is that a spin response of antiferromagnets is in the terahertz region (picosecond order) that is two to three orders of magnitude faster than that of ferromagnets, and an interaction between the antiferromagnets is weak, which provides the potential to achieve magnetic devices with higher speed and higher density.

### First Embodiment

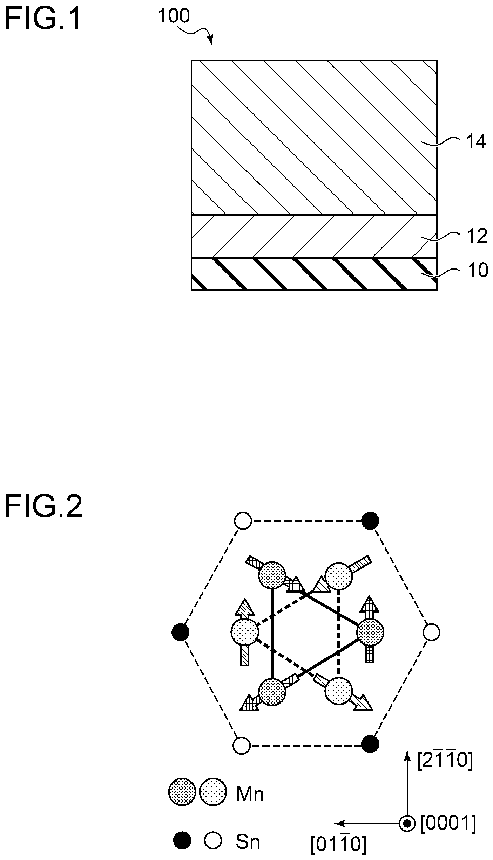

The first embodiment of the invention will be described with reference to FIGS. 1 to 8B.

First, a configuration of a magnetic memory element 100 according to the first embodiment will be described with reference to FIG. 1. The magnetic memory element 100 includes a substrate 10, a spin Hall layer 12 on the substrate 10, and an antiferromagnetic layer 14 on the spin Hall layer 12.

The substrate 10 is made of an insulator such as MgO. The spin Hall layer 12 is made of a material that exhibits a spin Hall effect (spin Hall material). Examples of such a material include a non-magnetic heavy metal such as tantalum (Ta), tungsten (W), and platinum (Pt), or a chalcogenide material such as a topological insulator. The antiferromagnetic layer 14 is a thin film made of an antiferromagnetic metal containing manganese (Mn). Examples of such an antiferromagnetic metal include Mn₃X (X=Sn, Ge, Ga, Rh, Pt, Ir), Mn₃XN (X=Ga, Sn, Ni), and a gamma-Mn alloy with a face-centered cubic (fcc) structure. Examples of such a gamma-Mn alloy include Mn₁₋ₓFeₓ, Mn₁₋ₓRhₓ, and Mn₁₋ₓPdₓ. Alternatively, a mixture of different Mn₃Xs (e.g., a mixture of Mn₃Sn and Mn₃Ga) and a mixture of Mn₃X and an infinitesimal amount of other element (e.g., a mixture of Mn₃Sn and an infinitesimal amount of Cr) may be employed as the material of the antiferromagnetic layer 14.

When a write current flows through the spin Hall layer 12 of the magnetic memory element 100 in an in-plane direction, a spin current is generated in an out-of-plane direction by the spin Hall effect and induces a spin-orbit torque (SOT) to act on magnetization of the antiferromagnetic layer 14, thereby allowing reversal of the magnetization.

Instead of the magnetic memory element 100 shown in FIG. 1, another configuration in which a spin Hall layer is stacked on an antiferromagnetic layer (substrate/ antiferromagnetic layer/ spin Hall layer) may be employed. In still another configuration, an antiferromagnetic layer may be sandwiched by two spin Hall layers made of spin Hall materials whose spin Hall angles are opposite in sign. The focus below will be on the magnetic memory element 100 shown in FIG. 1.

Next, a method for fabricating the magnetic memory element 100 will be explained. Given below is an example of forming a W(7 nm)/Mn₃Sn(30 nm) /MgO(5 nm) multilayer film on a MgO(110) substrate. The MgO(5 nm) layer is provided to prevent oxidation of the Mn₃Sn layer. The thickness (nm) of each layer of the magnetic memory element 100 is illustrative only and not restrictive.

First, the MgO substrate is annealed at 800 °C for 10 minutes in an ultrahigh vacuum chamber. The W(7 nm)/Mn₃Sn(30 nm)/MgO(5 nm) multilayer film is fabricated on the MgO(110) substrate by a molecular beam epitaxy (MBE) method under ultrahigh vacuum with base pressure of 2×10⁻⁸ Pa. The W(7 nm) layer is deposited at a rate of 0.1 Å/s at 300 °C, and subsequently, it is annealed at 800 °C for 10 minutes. The Mn₃Sn(30 nm) layer is fabricated at a rate of 0.25 Å/s with co-evaporation of Mn and Sn. The Mn₃Sn(5 nm) layer is firstly deposited at room temperature and then annealed at 400 °C. Subsequently, the additional Mn₃Sn(25 nm) layer is deposited at approximately 260 °C.

In-situ reflection high energy electron diffraction (RHEED) images show sharp streak patterns, which suggest the epitaxial growth of the W and Mn₃Sn layers in this fabrication process.

After that, the MgO layer is fabricated at a rate of 0.1 Å/s at room temperature. Finally, the MgO(110)-substrate/W(7 nm)/Mn₃Sn(30 nm)/MgO(5 nm) multilayer film is annealed at 650 °C for 30 minutes. Instead of the MBE method, a sputtering method can be used in the same annealing process to fabricate a multilayer film having the same property as the MBE-fabricated multilayer film.

Next, characteristics of Mn₃Sn will be explained as an example of an antiferromagnetic metal constituting the antiferromagnetic layer 14 with reference to FIG. 2.

Mn₃Sn is an antiferromagnet having a crystal structure called kagome lattice that is a triangle-based lattice in which kagome lattice layers are stacked in [0001] direction as shown in FIG. 2. Mn atoms located at vertices of kagome lattice have a non-collinear magnetic structure in which magnetic moments (directions of localized spins) are oblique to each other by 120 degrees at temperature of 420 K or below due to geometrical frustration. A unit of six spins consisting of two sets of three spins residing on a kagome lattice bilayer forms a spin order called a cluster magnetic octupole depicted as hexagon. Such a non-collinear magnetic structure can be viewed as ferroic order of the cluster magnetic octupole. This ferroic order breaks the time-reversal symmetry macroscopically.

The cluster magnetic octupole corresponds to a direction of a fictitious magnetic field in a momentum space (100 to 1000 Tesla (T) in a real space) and Weyl points which have a topological electronic structure. Hence, it is possible to manipulate the responses originating from the fictitious magnetic field and Weyl points based on the direction of the cluster magnetic octupole.

The magnetic structure shown in FIG. 2 has orthorhombic symmetry, and one of the three magnetic moments of Mn atoms which are triangularly arranged is parallel to an easy axis of magnetization. The other two magnetic moments are canted with respect to the easy axis of magnetization, and thus are believed to induce a weak ferromagnetic moment. Such an antiferromagnet having a canted magnetic moment to exhibit a tiny magnetization is called a canted antiferromagnet.

The crystal orientation of Mn₃Sn plays an important role in enhancement of a readout signal from the magnetic memory element. For example, in an anomalous Hall effect measurement which will be described later, only crystal grains having an out-of-plane component of the magnetic order of the cluster magnetic octupole (i.e., a component perpendicular to a surface of the substrate 10) contribute to a Hall voltage.

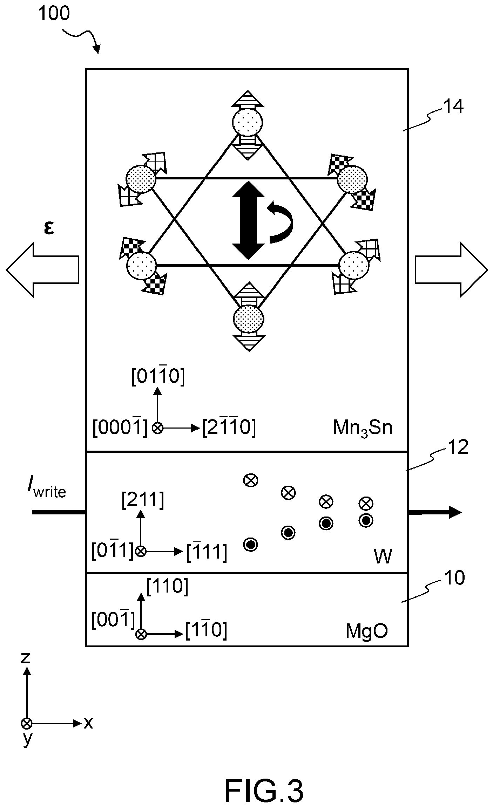

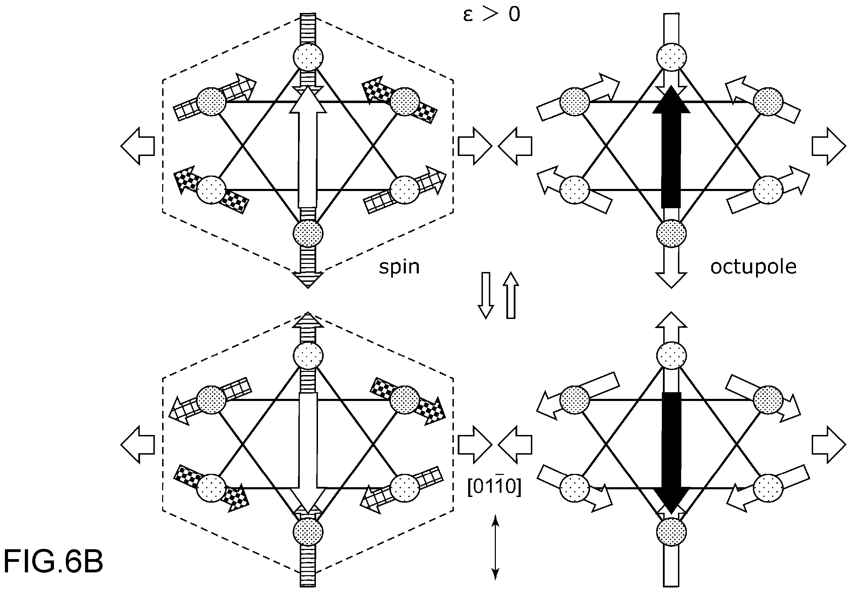

When the W/Mn₃Sn layer is fabricated on the MgO substrate as described above, a tensile strain ε is created in the Mn₃Sn layer in [2-1-10]-direction (in-plane direction) as shown in FIG. 3. This causes the magnetic order of the cluster magnetic octupole to be oriented in an out-of-plane direction, and defines binary states (up, down) on the kagome layers (See FIG. 6B).

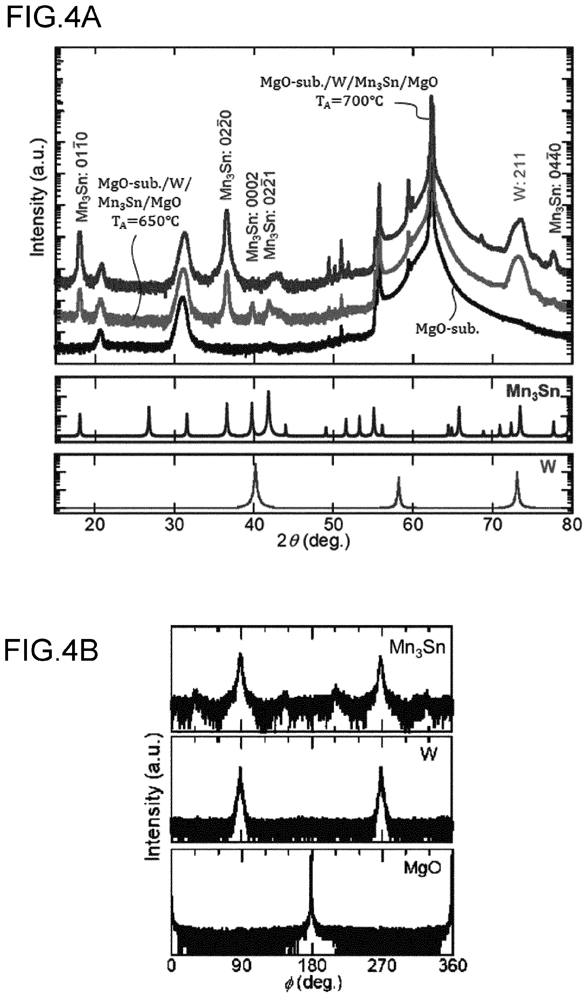

To investigate a crystal structure of the Mn₃Sn layer, X-ray diffraction is employed. FIG. 4A shows X-ray diffraction patterns of 28/ω-scan for the MgO(110)-substrate/W(7 nm) /Mn₃Sn (30 nm) /MgO (5 nm) samples and the MgO (110) -substrate. The X-ray diffraction patterns for the MgO(110)-substrate/W(7 nm)/Mn₃Sn(30 nm)/MgO(5 nm) samples are obtained when temperatures T_{A} of annealing after forming all the layers of the multilayer film are 650 °C and 700 °C. At bottom panels of FIG. 4A, theoretical spectra for D0₁₉-Mn₃Sn and α-W are presented. FIG. 4B shows X-ray diffraction patterns of Φ-scan for {02-21} planes of the Mn₃Sn layer, {110} planes of the W layer, and {200} planes of the MgO substrate.

The X-ray spectra of FIG. 4A reveal that the W layer has a (211) peak, and the Mn₃Sn layer has main peaks of (01-10), (02-20), and (04-40), confirming that the Mn₃Sn layer has a hexagonal D0₁₉ structure. FIG. 4A further reveals that the Mn₃Sn layer has minor peaks of (0002) and (02-21) at T_{A} = 650 °C, whereas these minor peaks are not seen at T_{A} = 700 °C.

The X-ray spectra of FIG. 4B shows that the {110} peak of the W layer and the {021} peak of the Mn₃Sn layer appear at 90 degrees off from the {200} peak of the MgO substrate. These results indicate that the Mn₃Sn layer is selectively oriented as MgO(110) [001] | |W(211) [01-1] | |Mn₃Sn(01-10) [0001]. This confirms that the kagome plane, where the cluster magnetic octupole is confined, is perpendicular to the film plane, as shown in FIG. 3.

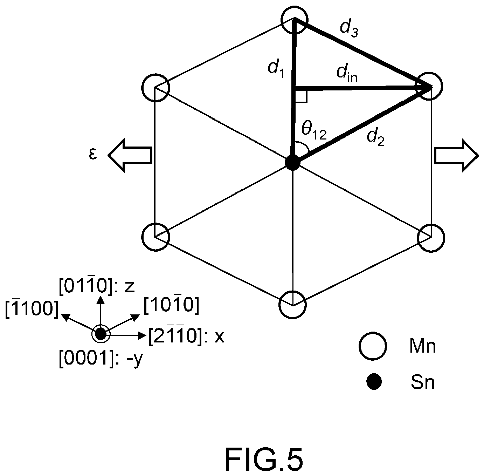

FIG. 5 shows an atomic arrangement of the Mn₃Sn layer of the MBE-grown film. By the X-ray diffraction for (02-20), (20-20) and (-2200) planes of the Mn₃Sn layer, inter-atomic distances d₁ and d₂ and an angle θ₁₂ of each triangle constituting the hexagon can be experimentally obtained. The other inter-atomic distance d₃ and the length dᵢₙ parallel to [2-1-10] direction (x-direction) can be calculated from d₁, d₂, and θ₁₂.

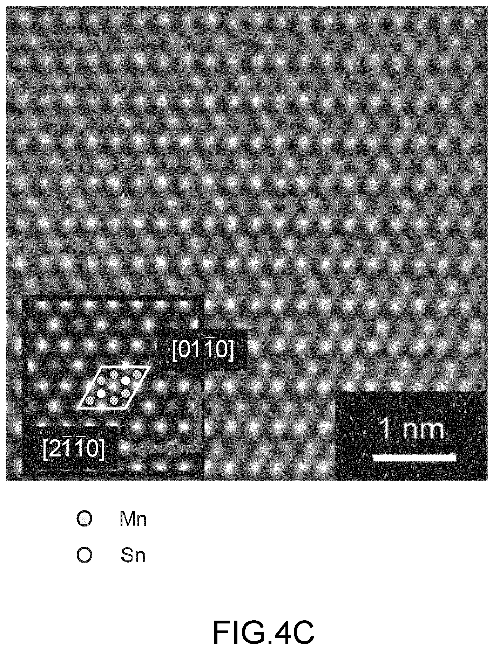

For a bulk Mn₃Sn, lattice constants are reported to be a = 5.665 Å and c = 4.531 Å, and d₁ = 4.903 Å, d₂ = 4.909 Å, d₃ = 4.906 Å, dᵢₙ = 4.251 Å, and θ₁₂ = 60.0°. For the Mn₃Sn layer of the MBE-grown film, d₁ = 4.904 Å, d₂ = 4.916 Å, d₃ = 4.939 Å, dᵢₙ = 4.261 Å, and θ₁₂ = 60.4°. In the Mn₃Sn layer of the MBE-grown film, compared to the bulk Mn₃Sn, d₂ is longer, θ₁₂ is larger, and dᵢₙ increases from 4.251 Å to 4.261 Å although d₁ remains almost the same. This indicates that the tensile strain (epitaxial strain) ε of about 0.2% exists in [2-1-10] direction (x-direction). The existence of the same strain can be evaluated from a cross-sectional transmission electron microscope (TEM) image shown in FIG. 4C. In FIG. 4C, a diamond shape represents a unit cell of Mn₃Sn.

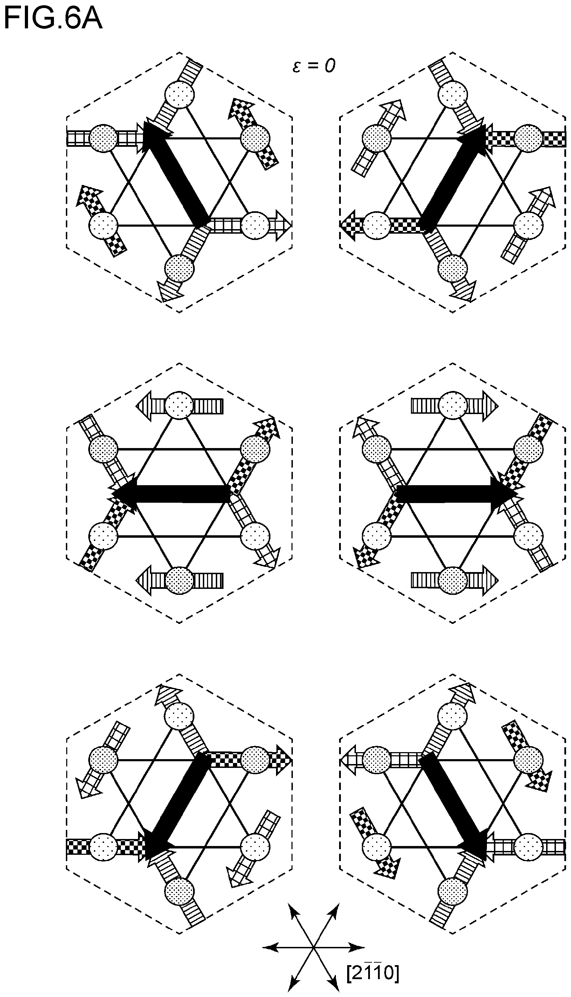

When the Mn₃Sn layer has no strain (ε=0), the spin structure on the kagome layers possesses 6-degenerate states with the cluster magnetic octupole pointing along 6-equivalent {2-1-10} as shown in FIG. 6A. When the Mn₃Sn layer has an epitaxial, uniaxial-tensile strain (ε>0) in an in-plane direction, on the other hand, the magnetic order of the cluster magnetic octupole is oriented along an out-of-plane direction as shown in FIG. 6B, which defines binary states: a parallel state (up) and an anti-parallel state (down) with respect to [01-10] direction. This makes it possible to represent binary data ("0" and "1").

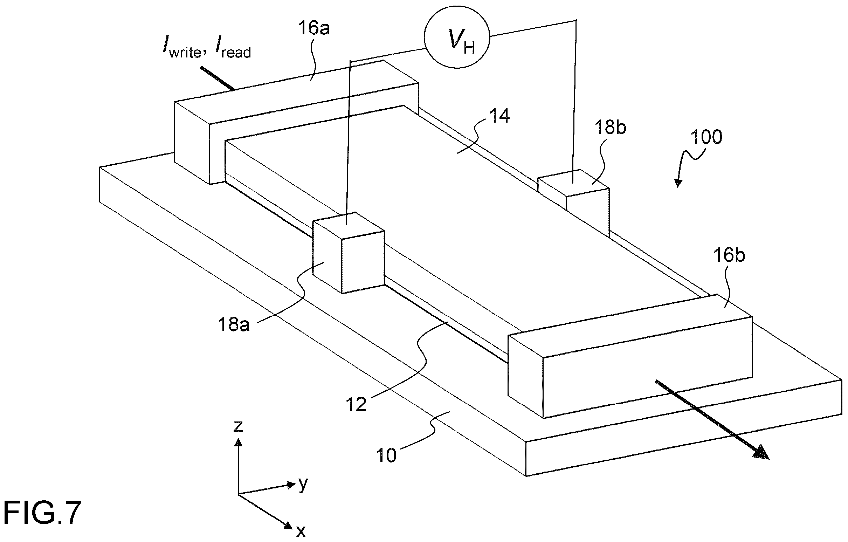

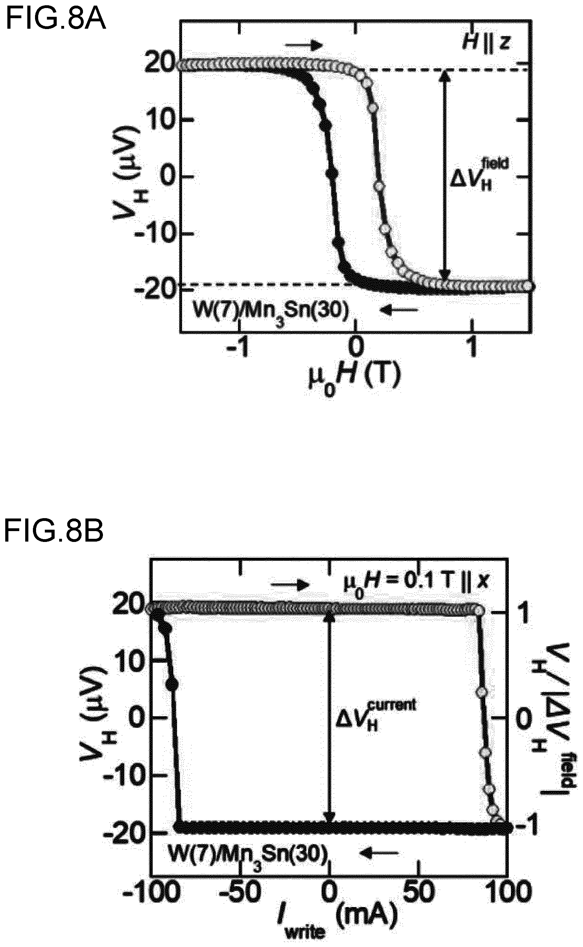

Next, the anomalous Hall effect, a write operation, and a read operation of the magnetic memory element 100 will be explained with reference to FIGS. 7, 8A, and 8B.

FIG. 7 shows a configuration of the magnetic memory element 100 with a Hall bar structure. A pair of electrodes 16a and 16b made of Au/Ti is disposed on both ends of a sample of the magnetic memory element 100 in a longitudinal direction (x-direction), and a pair of electrodes 18a and 18b made of Au/Ti is disposed in a short direction (y-direction). A write current I_{write} or a read current I_{read} flows between the electrodes 16a and 16b, and a Hall voltage V_{H} is detected between the electrodes 18a and 18b.

To write data into the magnetic memory element 100, the write current I_{write} (pulse current) flows through the spin Hall layer 12 in the longitudinal direction (x-direction). This write current generates a spin current in an out-of-plane direction (z-direction) by the spin Hall effect, and this spin current induces an SOT to act on the magnetization of the antiferromagnetic layer 14, thereby allowing reversal of the magnetization. Here, a weak bias field Hₓ applying in x-direction affects the magnetization of the antiferromagnetic layer 14, and determines a rotational direction of the magnetization.

In this way, the data ("0" or "1") can be written into the antiferromagnetic layer 14. The direction of the magnetization of the antiferromagnetic layer 14 can be manipulated depending on the direction of the write current I_{write}. For example, the write current I_{write} flowing in +x-direction reverses the magnetization from +z-direction ("1") to -z-direction ("0"), and the write current I_{write} flowing in -x-direction reverses the magnetization from -z-direction ("0") to +z-direction ("1").

To read out the data stored in the antiferromagnetic layer 14, the read current I_{read} (direct current) flows through the antiferromagnetic layer 14 in x-direction. This read current generates the Hall voltage V_{H} in y-direction by the anomalous Hall effect. The sign of the Hall voltage V_{H} is determined depending on the z-component of the magnetization of the antiferromagnetic layer 14. For example, +z-direction and -z-direction of the magnetization of the antiferromagnetic layer 14 are equivalent to "1" and "0," respectively.

Next, measurement results of the anomalous Hall effect on the magnetic memory element 100 will be explained with reference to FIGS. 8A and 8B. A multilayer film of the magnetic memory element 100 used for the measurement is W(7 nm)/Mn₃Sn(30 nm) on a MgO substrate.

FIG. 8A shows the Hall voltage V_{H} as a function of a perpendicular magnetic field H (i.e., a magnetic field in z-direction) at room temperature. As shown in FIG. 8A, a clear hysteresis of the Hall voltage V_{H} is observed. The difference ΔV_{H}^{field} at zero magnetic field (Hall voltage change) between the Hall voltage V_{H} when the magnetic field H is swept from negative to positive and the Hall voltage V_{H} when the magnetic field H is swept from positive to negative is found to be about 40 µV.

FIG. 8B shows the Hall voltage V_{H} as a function of a write current I_{write} at room temperature when a bias magnetic field µ₀H of 0.1 T is applied in x-direction to the W(7 nm)/Mn₃Sn(30 nm) multilayer film. Here, the write current I_{write} is applied followed by the read current I_{read} to measure the Hall voltage V_{H}. As shown in FIG. 8B, a clear hysteresis is observed, and a jump in the Hall voltage V_{H} under the write current I_{write} larger than a threshold corresponds to reversal of the magnetic order (magnetization reversal) of the cluster magnetic octupole.

The difference (Hall voltage change) between the Hall voltage V_{H} when the write current I_{write} is swept from negative to positive and the Hall voltage V_{H} when the write current I_{write} is swept from positive to negative is denoted by ΔV_{H}^{current} A ratio ΔV_{H}^{current}/|ΔV_{H}^{field}| is a switching ratio that indicates a ratio of domains that are actually switched to all switchable domains. FIG. 8B also shows that ΔV_{H}^{current} is about 40 µV, and hence ΔV_{H}^{current}/|ΔV_{H}^{field}| becomes 1 (i.e., the switching ratio is 100%). This suggests that all switchable domains in the Mn₃Sn layer with a thickness of 30 nm can actually be switched by the write current I_{write} under the perpendicular magnetic field.

The results of FIGS. 8A and 8B indicate that perpendicular magnetic anisotropy appears in the Mn₃Sn layer due to the in-plane epitaxial strain. This is believed to be caused by manipulation of the magnetic anisotropy based on a piezomagnetic effect as described below in the second embodiment. This results in stable binary states in the antiferromagnetic state, and fluctuation in signal is hardly seen even if the magnetic memory element 100 is infinitesimal in size, leading to improvement of the operation reliability.

In the above-described experiment, the epitaxial strain of about 0.2% can be applied in the Mn₃Sn layer using the MgO substrate. It is known that the epitaxial strain is typically allowed to increase up to several percent. Thus, the epitaxial strain enables the reversal speed of magnetization in the antiferromagnetic layer 14 to increase up to 1ps to 10ps (10GHz to 1THz).

As described above, according to the magnetic memory element 100 of the first embodiment, the in-plane epitaxial strain in the antiferromagnetic layer allows the magnetic order of the cluster magnetic octupole, which characterizes the antiferromagnetic state, to be oriented in a direction perpendicular to the strain direction, making it possible to define the binary states. Consequently, the antiferromagnet-based magnetic memory element can achieve high-speed write and read operations.

### Second Embodiment

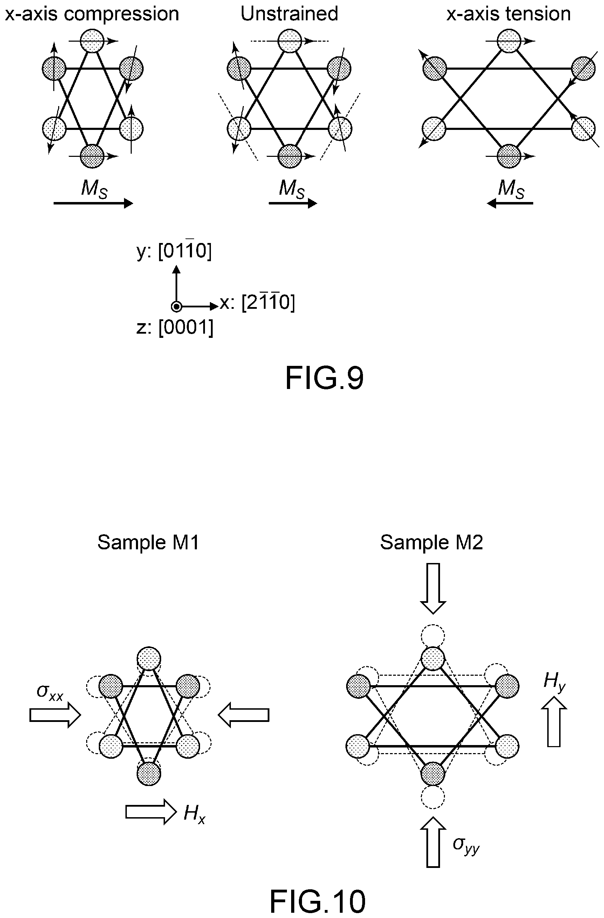

The second embodiment of the invention will be described with reference to FIGS. 9 to 15B.

In the second embodiment, the manipulation of the magnetic anisotropy in an antiferromagnetic layer based on the piezomagnetic effect will be described. To date, the studies of the piezomagnetic effect have been primarily restricted to antiferromagnetic insulators at cryogenic temperatures. However, the inventors of the present application were able to discover the piezomagnetic effect in an antiferromagnetic metal at room temperature or higher, as described below.

A magnetic memory element of the second embodiment has the same structure as that of the magnetic memory element 100 of the first embodiment (FIG. 1), and materials of a multilayer film of the magnetic memory element are the same as those in the first embodiment. Also in the second embodiment, Mn₃Sn will be mentioned as an example of an antiferromagnetic metal.

When uniaxial strain is applied from outside to the magnetic memory element, the magnetic anisotropy can be manipulated by the piezomagnetic effect in the antiferromagnetic layer. As shown in a middle of FIG. 9, when the Mn₃Sn layer is in an unstrained state, there is a small spontaneous magnetization M_{S} (in [2-1-10] direction (+x-direction) in FIG. 9) as described above. When uniaxial stress is applied to a sample of the magnetic memory element, the nearest-neighbor exchange interactions become anisotropic. For example, as shown in the left of FIG. 9, under compression in a horizontal direction (x-direction) at zero magnetic field, the horizontal bonds become shorter, the exchange interaction across these bonds increases, and spins connected by the horizontal bonds rotate to become more nearly anti-parallel along γ-direction. This increases the spontaneous magnetization M_{S} along +x. In contrast, under tensile strain in the horizontal direction at zero magnetic field, the spontaneous magnetization M_{S} increases along -x as shown in the right of FIG. 9.

Next, magnetization measurements for two samples M1 and M2 with different compression directions will be explained. Both the samples M1 and M2 are Mn₃Sn single crystals. As shown in FIG. 10, the sample M1 is under uniaxial stress σₓₓ along the x-direction applied from right and left sides, and the sample M2 is under uniaxial stress σ_{yy} along the y-direction applied from above and underneath. The sample M1 is under a magnetic field Hₓ in [2-1-10] direction (+x-direction), and the sample M2 is under a magnetic field H_{y} in [01-10] direction (+y-direction). For example, the uniaxial stress is applied to these sample using a piston-cylinder type pressure cell described in Non-Patent Literature below: Kittaka, S., Taniguchi, H., Yonezawa, S., Yaguchi, H. & Maeno, Y. "Higher-Tc superconducting phase in Sr2RuO4 induced by uniaxial pressure" Phys. Rev. B 81, 180510 (2010).

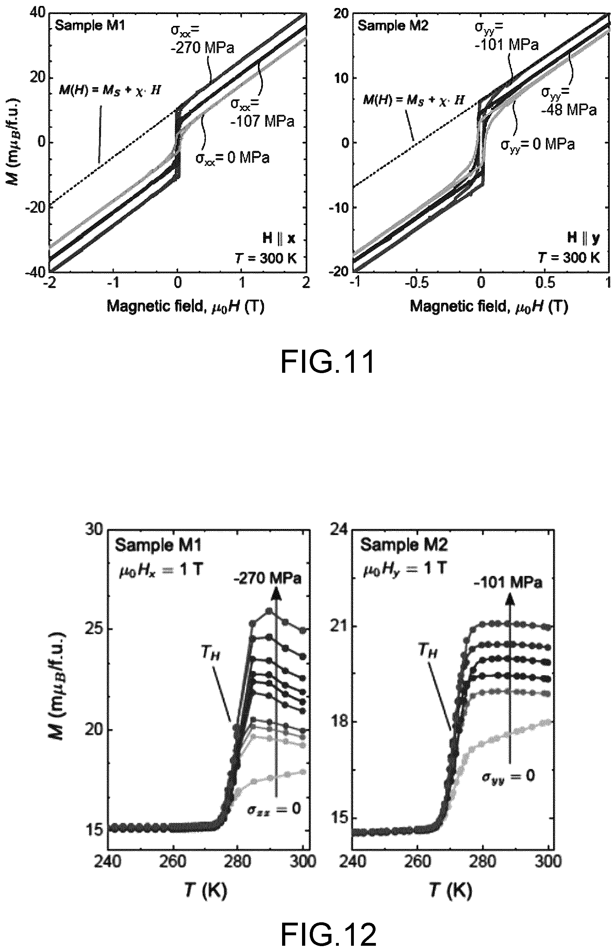

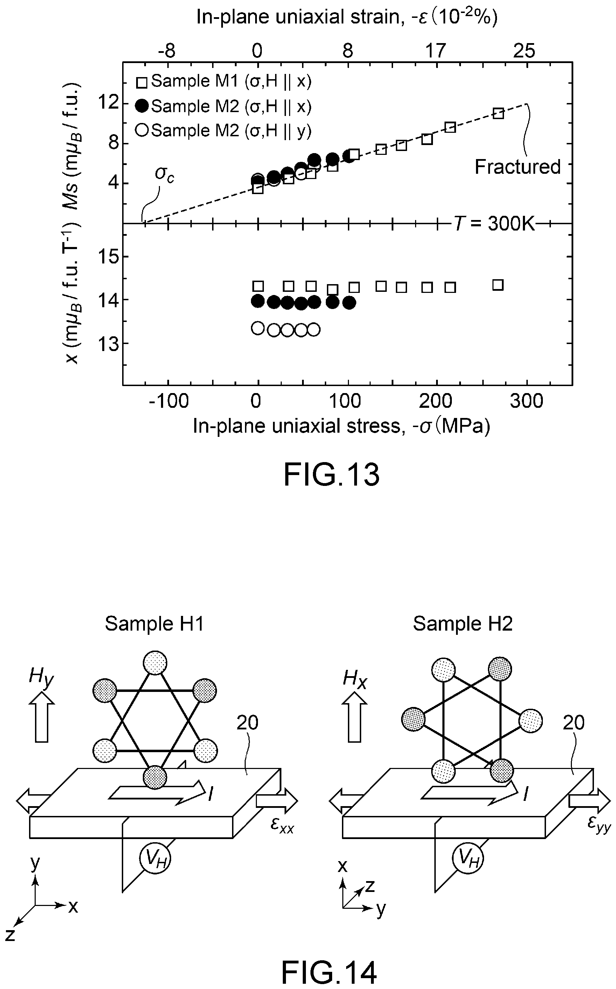

In the following explanation, negative strain indicates compressive strain and positive strain indicates tensile strain. FIG. 11 shows magnetic field dependence of the magnetization M at 300 K (room temperature) under σₓₓ = 0 MPa, -107 MPa, -270 MPa for the sample M1, and magnetic field dependence of the magnetization M at 300 K (room temperature) under σ_{yy} = 0 MPa, -48 MPa, -101 MPa for the sample M2. FIG. 12 shows temperature dependence of the magnetization M under a magnetic field of µ₀Hₓ = 1 T and various uniaxial stresses (σₓₓ = 0 to -270 MPa) for the sample M1, and temperature dependence of the magnetization M under a magnetic field of µ₀H_{y} = 1 T and various uniaxial stresses (σ_{yy} = 0 to -101 MPa) for the sample M2. FIG. 13 shows uniaxial stress dependence of the spontaneous magnetization M_{S} and magnetic susceptibility χ for the samples M1 and M2 at 300 K. For the sample M2 in FIG. 13, filled circles denote data points taken under the stress and the magnetic field Hₓ applied along x-direction, and open circles denote data points taken under the stress and the magnetic field H_{y} applied along y-direction.

FIG. 11 indicates that under zero stress (σₓₓ = 0), the sample M1 exhibits M_{S} of 3.6 mµ_{B}/f.u. and an extremely small coercivity of 0.03 T, whereas under σₓₓ = -270 MPa, the sample M1 exhibits M_{S} of 10.7 mµ_{B}/f.u. showing about a threefold increase. In both the samples M1 and M2, the magnetization M increases linearly with the magnetic field except for a low magnetic field region, and its slope represents the magnetic susceptibility χ. Dotted line in each graph of FIG. 11 represents a linear fit to the data in a positive magnetic field region, which is given by M(H) = M_{S} + χ·H. For the sample M1, χ = µ₀⁻¹(∂M/∂Hₓ) = 14.3 mµ_{B}/f.u.T⁻¹. For the sample M2, χ = µ₀⁻¹(∂M/∂H_{y}) = 13.5 mp_{B}/f.u.T⁻¹. As is clear from FIG. 11, no change is seen in the shape of hysteresis curve and the magnetic susceptibility χ with respect to the stress. This confirms that below the yield stress, sample quality does not degrade, and that the magnetization M represents magnetization of a single magnetic domain.

FIG. 12 reveals that the magnetization M increases with an increase in stress above an incommensurate transition temperature T_{H} (= 270 K to 280 K) for both the samples M1 and M2.

From the top panel of FIG. 13, the stress dependence of M_{S} is found to be linear for both the samples M1 and M2 and nearly isotropic in xy-plane for the sample M2. The linear fit to the data (dotted line) indicates that a critical stress σ_{c} at which M_{S} becomes zero is inferred to be about 120 MPa in the tensile stress region (σ > 0). From the bottom panel of FIG. 13, the magnetic susceptibility χ is found to be stress independent. The samples fracture at a stress higher than 300 MPa.

Next, the anomalous Hall effect on two samples H1 and H2 with different strain directions will be explained. As shown in FIG. 14, both the samples H1 and H2 are samples of single-crystalline antiferromagnetic layers 20 made of Mn₃Sn, a strain εₓₓ and a magnetic field H_{y} are applied to the sample H1 in x-direction and y-direction, respectively, and a strain ε_{yy} and a magnetic field Hₓ are applied to the sample H2 in y-direction and x-direction, respectively. To measure the anomalous Hall effect under various strains, a piezoelectric-based strain device described in Non-Patent Literature below is employed: Hicks, C. W., Barber, M. E., Edkins, S. D., Brodsky, D. O. & Mackenzie, A. P. "Piezoelectric-based apparatus for strain tuning" Rev. Sci. Instrum. 85, 065003 (2014).

When an electric current I flows through each of the samples H1 and H2 along the strain direction, an in-plane Hall voltage V_{H} perpendicular to the electric current I is measured. When a thickness (length in an out-of-plane direction) and Hall resistivity of the antiferromagnetic layer 20 are denoted by t and p, respectively, V_{H} = ρ·I/t is satisfied.

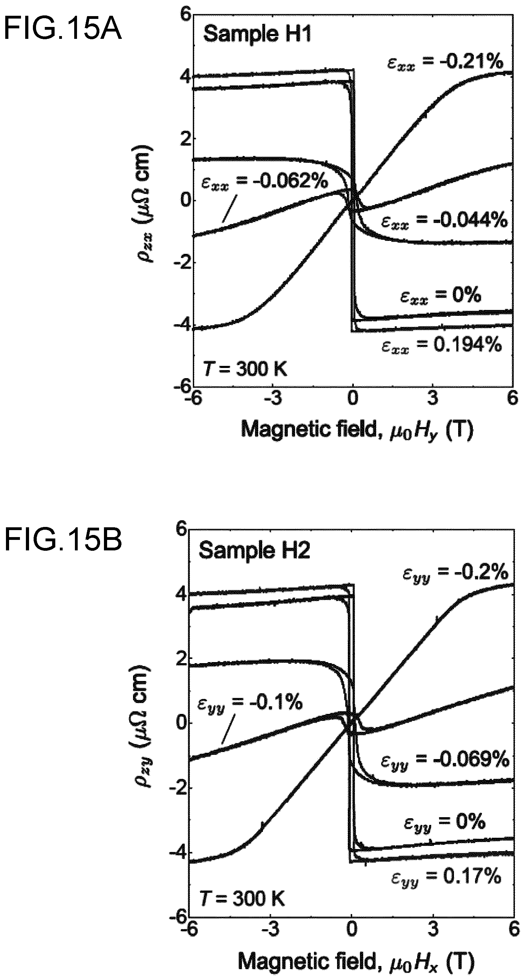

FIG. 15A shows magnetic field dependence of Hall resistivity ρ_{zx} at 300 K under various strains εₓₓ for the sample H1. FIG. 15B shows magnetic field dependence of Hall resistivity ρ_{zy} at 300 K under various strains ε_{yy} for the sample H2. FIG. 15A indicates that at zero strain (εₓₓ = 0%), the Hall resistivity ρ_{zx} exhibits a sharp hysteresis curve with the Hall resistivity at zero magnetic field of ρ_{zx} (H_{y} = 0) = -3.85 µΩcm and coercivity of about 0.04 T. Under the tensile strain of εₓₓ = 0.194%, the overall shape of the hysteresis curve is maintained, showing ρ_{zx} (H_{y} = 0) = -4.2 µΩcm, which indicates that magnitude of the Hall resistivity is enhanced by about 10% from its unstrained value. For the compressive strain (εₓₓ < 0%), ρ_{zx} (H_{y} = 0) gradually decreases with an increase in compression and vanishes for εₓₓ < -0.2%. For εₓₓ < -0.06%, there is a region where ρ_{zx} is linear with respect to the magnetic field. At εₓₓ =-0.21%, ρ_{zx} increases linearly with a slope µ₀⁻¹ (∂ρ_{zx}/∂H_{y}) of about 1 µΩcmT⁻¹ until it reaches a positive saturation value of ρ_{zx} = +4 µΩcm at µ₀H_{y} = +3.8 T. As shown in FIG. 15B, the Hall resistivity ρ_{zy} of the sample H2 exhibits almost the same behavior as that of the sample H1.

As described above, since the magnetic order of the cluster magnetic octupole is oriented in a direction of applying the compressive strain, a readout signal by the anomalous Hall effect or a magnetoresistance effect (to be described later) can be enhanced in the direction of applying the compressive strain. Thus, by applying the compressive strain, it is possible to manipulate magnitude of magnetization, the anomalous Hall effect, and the magnetoresistance effect. Consequently, the antiferromagnet-based magnetic memory element can achieve high-speed write and read operations.

The antiferromagnetic layers shown in the first and second embodiments may be single-crystalline films or polycrystalline films. The same holds true for a free layer (antiferromagnetic layer) in the third embodiment below.

### Third Embodiment

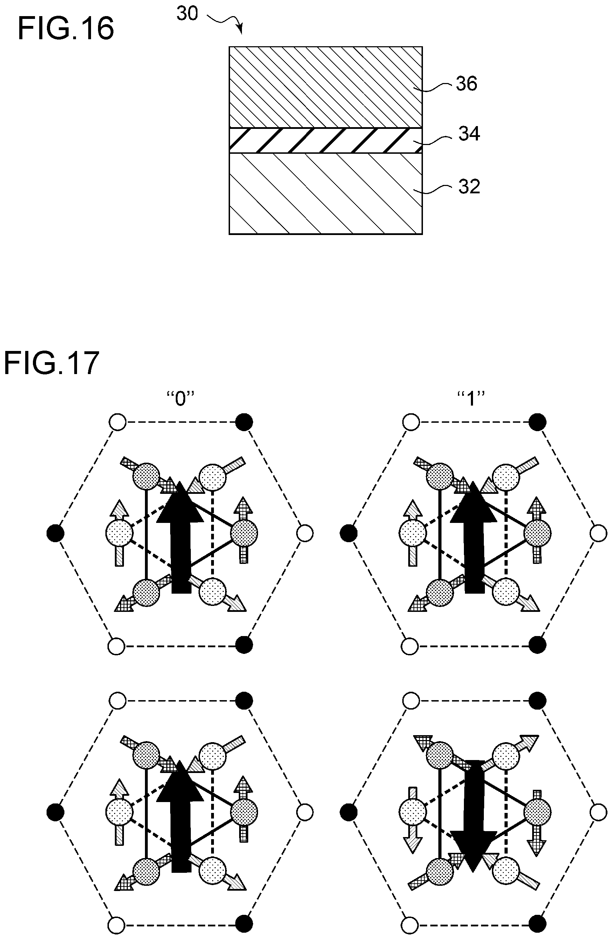

The third embodiment of the invention will be described with reference to FIGS. 16 to 19. The third embodiment is directed to a magnetic memory element including a magnetoresistance element.

As shown in FIG. 16, a magnetoresistance element 30 includes a free layer 32 whose magnetization is reversible, a non-magnetic layer 34 which is in contact with the free layer 32, and a reference layer 36 which is in contact with the non-magnetic layer 34 and whose magnetization is fixed in an in-plane direction or an out-of-plane direction. The non-magnetic layer 34 is made of an insulator (e.g., MgO, AlOx, MgAl₂O₄). Both the free layer 32 and the reference layer 36 are thin films made of the same antiferromagnetic metal as the antiferromagnetic layer 14 shown in FIG. 1, but the reference layer 36 has a higher coercivity than the free layer 32. The free layer 32 preferably has uniaxial strain (epitaxial strain or compressive strain) described in the first and second embodiments. The magnetoresistance element 30 serves as a magnetic tunnel junction (MTJ) element.

Data "0" and "1" are allocated to the magnetoresistance element 30 according to resistance states. For example, suppose that the free layer 32 and the reference layer 36 are made of Mn₃Sn. As shown in FIG. 17, when the magnetic order of the cluster magnetic octupole of the reference layer 36 and the magnetic order of the cluster magnetic octupole of the free layer 32 are oriented in the same direction (parallel state), the magnetoresistance element 30 is in a low-resistance state. When they are oriented in the opposite directions (anti-parallel state), the magnetoresistance element 30 is in a high-resistance state. It is therefore possible to allocate data of parallel state to "0" and data of anti-parallel state to "1." Experimentally, the magnetoresistance element 30 may become a high-resistance state in a parallel state, and become a low-resistance state in an anti-parallel state.

In a magnetoresistance element having ferromagnet/nonmagnet/ferromagnet trilayers, tunneling magnetoresistance (TMR) effect is observed to be proportional to spin polarization of ferromagnets. On the other hand, in a magnetoresistance element having antiferromagnet/nonmagnet/antiferromagnet trilayers, spin polarization of antiferromagnets is usually negligible, and hence TMR is not observed. For example, a spin polarization rate of the antiferromagnet Mn₃Sn is three orders smaller than that of iron (Fe) which is a ferromagnet.

However, in Mn₃Sn/MgO/Mn₃Sn multilayer films, a large TMR is observed without net spin polarization. Let tunnel resistance values of the magnetoresistance element in a high-resistance state and in a low-resistance state be denoted by R_{H} and R_{L}, respectively. A TMR ratio (%) is defined as {(R_{H} - R_{L})/R_{H}} × 100(%). The TMR ratio of about 1% is observed in Mn₃Sn/MgO/Mn₃Sn multilayer films and is larger than that observed in Fe/MgO/Mn₃Sn multilayer films. This indicates that polarization of the cluster magnetic octupole, instead of spin polarization, dominantly contributes to the TMR in Mn₃Sn/MgO/Mn₃Sn multilayer films. An even larger TMR ratio is expected for in-plane magnetization.

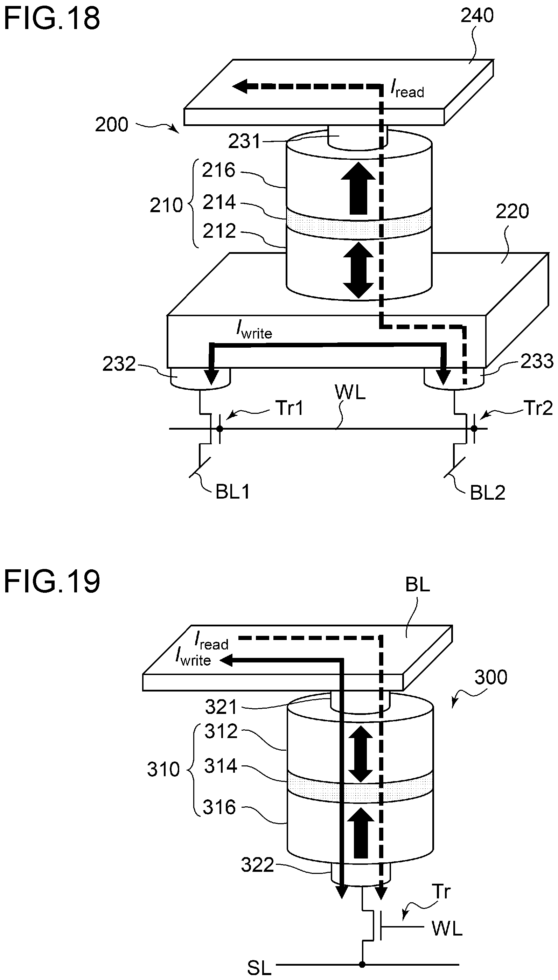

The magnetic memory element according to the third embodiment can be served as a magnetic random-access memory (MRAM) element. Magnetic memory elements for MRAMs will be explained below with reference to FIGS. 18 and 19.

FIG. 18 shows a configuration of a magnetic memory element 200 for an SOT-MRAM. The magnetic memory element 200 includes a magnetoresistance element 210, a spin Hall layer 220, a first terminal 231, a second terminal 232, a third terminal 233, and transistors Tr1 and Tr2.

The spin Hall layer 220 is made of a non-magnetic heavy metal that exhibits a spin Hall effect (such as W and Ta) or made of a chalcogenide material, as with the spin Hall layer 12 shown in FIG. 1. The magnetoresistance element 210 includes a free layer 212 which is stacked on the spin Hall layer 220 and whose magnetization is reversible, a non-magnetic layer 214 stacked on the free layer 212, and a reference layer 216 which is stacked on the non-magnetic layer 214 and whose magnetization is fixed in an out-of-plane direction. The materials of the free layer 212, the non-magnetic layer 214, and the reference layer 216 are the same as those of the free layer 32, the non-magnetic layer 34, and the reference layer 36 shown in FIG. 16, respectively.

The first terminal 231, the second terminal 232, and the third terminal 233 are made of a metal. The first terminal 231 is connected to the reference layer 216, the second terminal 232 is connected to one end portion of the spin Hall layer 220, and the third terminal 233 is connected to the other end portion of the spin Hall layer 220. The first terminal 231 is connected to a ground line 240. The ground line 240 is set to a ground voltage. The ground line 240 may be set to a reference voltage other than the ground voltage.

Each of the transistors Tr1 and Tr2 is, for example, an N-channel metal oxide semiconductor (NMOS) transistor. The second terminal 232 is connected to a drain of the transistor Tr1, and the third terminal 233 is connected to a drain of the transistor Tr2. Gates of the transistors Tr1 and Tr2 are connected to a word line WL. Sources of the transistors Tr1 and Tr2 are connected to a first bit line BL1 and a second bit line BL2, respectively.

Suppose that the magnetization of the free layer 212 and the magnetization of the reference layer 216 are oriented in an out-of-plane direction. To write data into the magnetoresistance element 210, a weak bias field is applied in a direction of a write current I_{write}, the word line WL is set to high level to turn on the transistors Tr1 and Tr2, one of the first bit line BL1 and the second bit line BL2 is set to high level, and the other bit line is set to low level. With these settings, the write current I_{write} flows through the spin Hall layer 220 in an in-plane direction between the first bit line BL1 and the second bit line BL2 to generate a spin current, which induces an SOT to allow reversal of the magnetization of the free layer 212 and thereby write the data. Data to be written can be changed depending on the direction of the write current I_{write}.

To read out the data stored in the magnetoresistance element 210, the word line WL is set to high level to turn on the transistors Tr1 and Tr2, one of the bit lines (second bit line BL2) is set to high level, and the other of the bit lines (first bit line BL1) is set to an open state. With these settings, a read current I_{read} flows from the second bit line BL2 in high level into the ground line 240 through the third terminal 233, the spin Hall layer 220, the free layer 212, the non-magnetic layer 214, the reference layer 216, and the first terminal 231. By measuring the magnitude of the read current I_{read} by the magnetoresistance effect, it is possible to determine the resistance state of the magnetoresistance element 210, i.e., the stored data.

FIG. 19 shows a configuration of a magnetic memory element 300 for an STT-MRAM whose magnetization is reversed by a spin transfer torque (STT). The magnetic memory element 300 includes a magnetoresistance element 310, a first terminal 321, a second terminal 322, and a transistor Tr.

The magnetoresistance element 310 includes a reference layer 316 whose magnetization is fixed in an out-of-plane direction, a non-magnetic layer 314 stacked on the reference layer 316, and a free layer 312 which is stacked on the non-magnetic layer 314 and whose magnetization is reversible. The materials of the free layer 312, the non-magnetic layer 314, and the reference layer 316 are the same as those of the free layer 32, the non-magnetic layer 34, and the reference layer 36 shown in FIG. 16, respectively.

The first terminal 321 and the second terminal 322 are made of a metal. The free layer 312 is connected to the first terminal 321, and the reference layer 316 is connected to the second terminal 322. The first terminal 321 is connected to a bit line BL, and the second terminal 322 is connected to the transistor Tr.

The transistor Tr is, for example, an NMOS transistor. The transistor Tr has a drain connected to the second terminal 322, a source connected to a source line SL, and a gate connected to a word line WL.

To write data into the magnetoresistance element 310, the word line WL is set to high level to turn on the transistor Tr, and a write current I_{write} flows in an out-of-plane direction between the bit line BL and the source line SL. This induces an STT to allow reversal of the magnetization of the free layer 312 and thereby write the data. Data to be written can be changed depending on the direction of the write current I_{write}.

To read out the data stored in the magnetoresistance element 310, the word line WL is set to high level to turn on the transistor Tr, and a read current I_{read} flows between the bit line BL and the source line SL. By measuring the magnitude of the read current I_{read} by the magnetoresistance effect, it is possible to determine the resistance state of the magnetoresistance element 310, i.e., the stored data.

Although MTJ elements are shown as examples of the magnetoresistance elements 30, 210, and 310 in FIGS. 16, 18, and 19, these magnetoresistance elements can serve as giant magnetoresistance (GMR) elements as well. In this case, the non-magnetic layers 34, 214, and 314 are made of a metal (conductor). Although the reference layer 216 in FIG. 18 and the reference layer 316 in FIG. 19 are made of an antiferromagnetic metal in the third embodiment, these reference layers may be ferromagnetic layers made of a ferromagnet (e.g., CoFeB). Furthermore, in FIG. 18, an ultrathin ferromagnetic layer made of a ferromagnet (e.g., CoFeB) with a thickness of 2nm or less may be stacked on the antiferromagnetic layer as the free layer 212 to employ another magnetoresistance element of [antiferromagnetic layer/ferromagnetic layer] (free layer)/non-magnetic layer/ferromagnetic layer (reference layer). This stacking structure may be turned upside down to employ still another magnetoresistance element of ferromagnetic layer (reference layer)/non-magnetic layer/[ferromagnetic layer/antiferromagnetic layer] (free layer) in FIG. 19. If the antiferromagnetic layer is thus magnetically coupled to the ultrathin ferromagnetic layer, it is possible not only to achieve fast manipulation rivaling the antiferromagnet but also to utilize the spin polarization of the ferromagnet, which holds promise for a high-speed memory.

A plurality of magnetic memory elements 200 may be arranged in a matrix to constitute a magnetic memory device in FIG. 18. A plurality of magnetic memory elements 300 may be similarly arranged in a matrix to constitute a magnetic memory device in FIG. 19. Moreover, a computer system or an information processing system including such a magnetic memory device may be constructed.

The invention is not limited to the above-described embodiments, and various modifications can be made without departing from the scope of the invention. Reference Sign List

10: Substrate
12, 220: Spin Hall layer
14, 20: Antiferromagnetic layer
100, 200, 300: Magnetic memory element
16a, 16b, 18a, 18b: Electrode
30, 210, 310: Magnetoresistance element
32, 212, 312: Free layer
34, 214, 314: Non-magnetic layer
36, 216, 316: Reference layer

## Claims

1. A magnetic memory element comprising:
an antiferromagnetic layer having a uniaxial strain and made of an antiferromagnetic metal containing manganese, a spin torque being configured to allow manipulation of a magnetic order of the antiferromagnetic metal.

2. The magnetic memory element according to claim 1, wherein
the antiferromagnetic layer has a tensile strain as the uniaxial strain.

3. The magnetic memory element according to claim 1, wherein
the antiferromagnetic layer has a compressive strain as the uniaxial strain.

4. The magnetic memory element according to claim 1, wherein
the antiferromagnetic layer is an epitaxial film.

5. The magnetic memory element according to claim 1, wherein
the antiferromagnetic metal is configured to exhibit an anomalous Hall effect.

6. The magnetic memory element according to claim 1, wherein
the antiferromagnetic metal has a spin order of a cluster magnetic octupole.

7. The magnetic memory element according to claim 6, wherein
the antiferromagnetic layer has a tensile strain as the uniaxial strain in an in-plane direction, and
the magnetic order of the cluster magnetic octupole is oriented perpendicularly to a direction of the tensile strain.

8. The magnetic memory element according to claim 6, wherein
the antiferromagnetic layer has a compressive strain as the uniaxial strain, and
the magnetic order of the cluster magnetic octupole is oriented in a direction of the compressive strain.

9. The magnetic memory element according to any one of claims 1 to 8, further comprising:
a spin Hall layer in contact with the antiferromagnetic layer and made of a material that exhibits a spin Hall effect, a write current flowing through the spin Hall layer in an in-plane direction being configured to generate a spin current, wherein
the spin current is configured to induce a spin-orbit torque to act on the magnetic order in the antiferromagnetic layer, thereby allowing reversal of the magnetic order.

10. A magnetic memory element comprising:
a spin Hall layer made of a material that exhibits a spin Hall effect, a write current flowing through the spin Hall layer in an in-plane direction being configured to generate a spin current;
a free layer stacked on the spin Hall layer, having a uniaxial strain, and made of an antiferromagnetic metal containing manganese, the spin current being configured to induce a spin-orbit torque that allows reversal of a magnetic order of the antiferromagnetic metal;
a non-magnetic layer stacked on the free layer; and
a reference layer stacked on the non-magnetic layer and made of a ferromagnetic metal or an antiferromagnetic metal containing manganese, a magnetic order of the ferromagnetic metal or the antiferromagnetic metal being fixed.

11. A magnetic memory element comprising:
a reference layer made of a ferromagnetic metal or an antiferromagnetic metal containing manganese, a magnetic order of the ferromagnetic metal or the antiferromagnetic metal being fixed;
a non-magnetic layer stacked on the reference layer; and
a free layer stacked on the non-magnetic layer, having a uniaxial strain, and made of an antiferromagnetic metal containing manganese, a write current flowing through the magnetic memory element in an out-of-plane direction being configured to induce a spin transfer torque that allows reversal of a magnetic order of the antiferromagnetic metal in the free layer.

12. An information processing system comprising the magnetic memory element according to any one of claims 1 to 8.

13. An information processing system comprising a magnetic memory device, the magnetic memory device comprising a plurality of magnetic memory elements arranged in a matrix, each of the plurality of magnetic memory elements being defined as the magnetic memory element according to any one of claims 1 to 8.

14. A method for controlling a magnetic memory element, the magnetic memory element comprising an antiferromagnetic layer having a uniaxial strain and made of an antiferromagnetic metal containing manganese,
the method comprising:
manipulating a magnetic order of the antiferromagnetic metal by a spin torque.

15. A method for controlling a magnetic memory element, the magnetic memory element comprising: a spin Hall layer made of a material that exhibits a spin Hall effect; a free layer stacked on the spin Hall layer, having a uniaxial strain, and made of an antiferromagnetic metal containing manganese; a non-magnetic layer stacked on the free layer; and a reference layer stacked on the non-magnetic layer and made of a ferromagnetic metal or an antiferromagnetic metal containing manganese, a magnetic order of the ferromagnetic metal or the antiferromagnetic metal being fixed,
the method comprising:
a step of causing a write current to flow through the spin Hall layer in an in-plane direction to generate a spin current; and
a step of reversing a magnetic order of the antiferromagnetic metal in the free layer by a spin-orbit torque induced by the spin current.

16. A method for controlling a magnetic memory element, the magnetic memory element comprising: a reference layer made of a ferromagnetic metal or an antiferromagnetic metal containing manganese, a magnetic order of the ferromagnetic metal or the antiferromagnetic metal being fixed; a non-magnetic layer stacked on the reference layer; and a free layer stacked on the non-magnetic layer, having a uniaxial strain, and made of an antiferromagnetic metal containing manganese,
the method comprising:
causing a write current to flow through the magnetic memory element in an out-of-plane direction, thereby reversing a magnetic order of the antiferromagnetic metal in the free layer by a spin transfer torque.
